# EUROPÄISCHE PATENTSCHRIFT

(11) **EP 0 869 551 B1**
(45) Veröffentlichungstag und Bekanntmachung des Hinweises auf die Patenterteilung: **02.01.2002**
(21) Anmeldenummer: 98106091.6
(22) Anmeldetag: 02.04.1998
(51) Int. Cl.: H01L 21/768

(54) **Leitende Verbindung zwischen zumindest zwei Gebieten eines ersten Leitfähigkeitstyps**
Interconnect structure between at least two areas of a first type of conductivity
Structure d'interconnexion entre au moins deux zones de même type de conductivité

(30) Priorität: 04.04.1997 DE 19713961
(43) Veröffentlichungstag der Anmeldung: 07.10.1998
(73) Patentinhaber: Infineon Technologies AG, 81669 München (DE)
(72) Erfinder: Heineck, Lars-Peter, 75012 Paris (FR)
(74) Vertreter: Zedlitz, Peter, Dipl.-Inf.

(56) Entgegenhaltungen:
- EP-A- 0 821 409
- US-A- 4 833 094
- US-A- 5 185 294
- US-A- 5 545 581

## Beschreibung

Die vorliegende Erfindung betrifft ein Verfahren zur Erzeugung einer leitenden Verbindung zwischen zumindest zwei Gebieten eines ersten Leitfähigkeitstyps, wobei insbesondere zumindest eines der Gebiete ein Source-/Draingebiet eines Transistors ist.

Bei der Herstellung von integrierten Halbleiterprodukten tritt häufig das Problem auf, daß zwei Gebiete eines Leitfähigkeitstyps, die voneinander beabstandet sind, durch eine leitende Verbindung verbunden werden müssen. Eine derartige Situation ist beispielsweise bei der Herstellung von hochintegrierten Speicherbauelementen gegeben. Speicherbauelemente bestehen aus einer Vielzahl von Speicherzellen, die üblicherweise jeweils einen Transistor und einen Speicherkondensator aufweisen. Ist nun der Speicherkondensator als ein Grabenkondensator ausgebildet, der die zu speichernde Ladung auf der innen liegenden Elektrode speichert, so muß diese innen liegende Elektrode mit einem der Source-/Draingebiete des Transistors verbunden sein, um ein Funktionieren der Speicherzelle zu gewährleisten.

Zur Herstellung einer derartigen Verbindung kann beispielsweise ein sogenannter "Surface-Strap" verwendet werden, wie er in der US-Patentschrift 5,185,294 offenbart ist. Es ist jedoch nicht einfach, das Herstellungsverfahren für den "Surface-Strap", wie es in der US-Patentschrift 5,185,294 beschrieben ist, oder ein ähnliches Verfahren in den Herstellungsprozeß für einen Transistor bzw. eine Speicherzelle zu integrieren.

Aus der nicht vorveröffentlichten EP 0 821 409 A2 ist dagegen bekannt, einen selbstjustierten Polysilizium-Strap zur Erzeugung der leitenden Verbindung zu verwenden. Dabei wird eine undotierte Polysiliziumschicht auf die mit Bor dotierten Bereiche der zu verbindenden Gebiete abgeschieden und thermisch behandelt, so daß dabei Bor in die noch undotierte Polysiliziumschicht diffundiert und ein durchgängig dotierter Polysiliziumabschnitt zwischen den beiden zu verbindenden Gebieten gebildet wird. Nachfolgend werden die undotierten Polysiliziumabschnitte selektiv und naßchemisch entfernt. Nachteilig bei diesem Verfahren ist, daß als Maskierungsschicht bei der Borimplantation eine Siliziumnitridschicht verwendet wird, die seitliche Randstege eines bereits vorhandenen Gate-Stacks bedeckt und dadurch den zur Verfügung stehenden Raum zwischen benachbarten Gate-Stacks eingrenzt. Dies setzt der weiteren Miniaturisierung Grenzen.

Es ist daher die Aufgabe der vorliegenden Erfindung, ein einfaches und kostengünstiges Verfahren zur Erzeugung einer leitenden Verbindung zwischen zumindest zwei Gebieten eines ersten Leitfähigkeitstyps, wobei insbesondere zumindest eines der Gebiete ein Source-/Draingebiet eines Transistors ist, bereitzustellen, das auch bei eng benachbarten Gate-Stacks eine sichere leitende Verbindung ermöglicht.

Diese Aufgabe wird von dem Verfahren gemäß Patentanspruch 1 gelöst. Weitere vorteilhafte Ausführungsformen, Ausgestaltungen und Aspekte der vorliegenden Erfindung ergeben sich aus den Unteransprüchen, der Beschreibung und den beiliegenden Zeichnungen.

Erfindungsgemäß wird ein Verfahren zur Erzeugung einer leitenden Verbindung zwischen zumindest zwei Gebieten eines ersten Leitfähigkeitstyps, wobei zumindest eines der Gebiete ein Source-/Draingebiet eines Transistors ist, bereitgestellt, das die folgenden Schritte umfaßt:
a) eine Halbleiterstruktur mit einem Substrat, in welchem zumindest ein erstes Gebiet des ersten Leitfähigkeitstyps und davon beabstandet ein Bereich eines zweiten Leitfähigkeitstyps ausgebildet sind, und einer auf dem Bereich des zweiten Leitfähigkeitstyps angeordneten Schichtanordnung, welche zumindest eine erste Isolationsschicht, eine leitende Schicht und eine zweite Isolationsschicht umfaßt, wird bereitgestellt,
b) auf die Halbleiterstruktur wird eine dritte Isolationsschicht aufgebracht,
c) mit einer Phototechnik wird eine Öffnung über zumindest einem Teil des Bereichs des zweiten Leitfähigkeitstyps und zumindest einem Teil des Gebiets des ersten Leitfähigkeitstyps erzeugt,
d) durch die Öffnung wird ein Dotierstoff des ersten Leitfähigkeitstyps in zumindest einen Teil des Bereichs des zweiten Leitfähigkeitstyps und, bevorzugt, zumindest einen Teil des Gebiets des ersten Leitfähigkeitstyps eingebracht,
e) auf die Halbleiterstruktur wird eine Polysiliziumschicht aufgebracht und eine Temperaturbehandlung durchgeführt, so daß ein Teil des Dotierstoffes des ersten Leitfähigkeitstyps in die Polysiliziumschicht und ein Teil des Dotierstoffes des ersten Leitfähigkeitstyps in den Bereich des zweiten Leitfähigkeitstyps diffundiert, so daß ein zweites Gebiet des ersten Leitfähigkeitstyps in dem Substrat entsteht,
f) der Teil der Polysiliziumschicht, in den kein Dotierstoff des ersten Leitfähigkeitstyps diffundiert ist, wird entfernt,
g) die dritte Isolationsschicht wird bis auf Isolationsbereiche entfernt, die an den Seiten der Schichtanordnung zurückbleiben,
h) ein Dotierstoff des ersten Leitfähigkeitstyps wird in zumindest einen Teil des Bereichs des zweiten Leitfähigkeitstyps eingebracht, so daß ein drittes Gebiet des ersten Leitfähigkeitstyps entsteht.

Das erfindungsgemäße Verfahren besitzt den Vorteil, daß die normalerweise für einen "Surface-Strap" anfallende Abscheidung einer zusätzlichen Nitridbarriereschicht entfallen kann. Die Funktion dieser zusätzlichen Nitridbarriereschicht wird von der ohnehin anfallenden dritten Isolationsschicht übernommen, die im weiteren Verlauf des Verfahrens die seitlichen Isolationsbereiche ("Spacer") an der auf dem Bereich des zweiten Leitfähigkeitstyps angeordneten Schichtanordnung ("Gatestack") bildet. Durch den Wegfall einer zusätzlichen Nitridbarriereschicht kann ein erheblicher Platzgewinn zwischen zwei Schichtanordnungen ("Gatestacks") erzielt werden. Dieser Platzgewinn hat zur Folge, daß die Speicherzelle weiter verkleinert werden kann und später folgende Abscheidungen eines Dielektrikums bzw. das Ätzen von Kontaktlöchern einfacher durchzuführen sind.

Darüber hinaus wird durch die Tatsache, daß das dritte Gebiet des ersten Leitfähigkeitstyps erst nach der Temperaturbehandlung zur Ausdiffusion des Dotierstoffs in die Polysiliziumschicht erzeugt wird, die Diffusion des Dotierstoffes unter die erste Isolationsschicht der Schichtanordnung erheblich reduziert. Dies führt zu einer Verringerung der elektrischen Felder in diesem Bereich und somit zu einer Verminderung der "GIDL"-Leckströme ("gate induced drain leakage") und zur Verbesserung des Verhaltens des Transistors, der aus der Schichtanordnung und dem zweiten sowie dem dritten Gebiet des ersten Leitfähigkeitstyps gebildet werden kann. Bei Anwendung des erfindungsgemäßen Verfahrens in einer Speicherzelle ergibt sich somit eine längere Verweilzeit der Information in der Zelle ("Retention Performance"). Durch die verringerte Ausdiffusion des Dotierstoffs unter die erste Isolationsschicht der Schichtanordnung kann auch die Dicke der Isolationsbereiche an den Seiten der Schichtanordnung weiter verringert werden, was wiederum zu einem erheblichen Platzgewinn zwischen zwei Schichtanordnungen ("Gatestacks") zur Folge hat. Auch dieser Platzgewinn hat zur Folge, daß die Speicherzelle weiter verkleinert werden kann und später folgende Abscheidungen eines Dielektrikums bzw. das Ätzen von Kontaktlöchern einfacher durchzuführen sind.

Bevorzugt ist die dritte Isolationsschicht eine Siliziumnitridschicht.

Weiterhin ist es bevorzugt, wenn auf der ersten leitenden Schicht eine zweite leitende Schicht vorgesehen ist. Dabei kann die erste leitende Schicht eine dotierte Polysiliziumschicht und die zweite leitende Schicht eine Wolframsilizidschicht sein.

Gemäß einer weiteren bevorzugten Ausführungsform wird vor dem Schritt b) eine dünne Oxidschicht auf die Halbleiterstruktur aufgebracht, wodurch ein dünner sogenannter Spacer an den Seiten der Schichtanordnung gebildet werden kann.

Ebenso ist bevorzugt, wenn vor Schritt b) ein Dotierstoff des ersten Leitfähigkeitstyps in zumindest einen Teil des Bereichs des zweiten Leitfähigkeitstyps eingebracht wird. Diese Dotierung kann zur Ausbildung einer "LDD-Transistorstruktur" genutzt werden.

Weiterhin ist es bevorzugt, wenn die Dotierstoffe des ersten Leitfähigkeitstyps implantiert werden.

Gemäß einer bevorzugten Ausführungsform der vorliegenden Erfindung wird der Teil der Polysiliziumschicht, in den kein Dotierstoff des ersten Leitfähigkeitstyps diffundiert ist, durch eine selektive Naßätzung mit KOH-Lauge entfernt.

Ebenso ist es bevorzugt, wenn der verbleibende Teil der Polysiliziumschicht oxidiert wird.

Als Dotierstoff des ersten Leitfähigkeitstyps wird bevorzugt Bor gewählt.

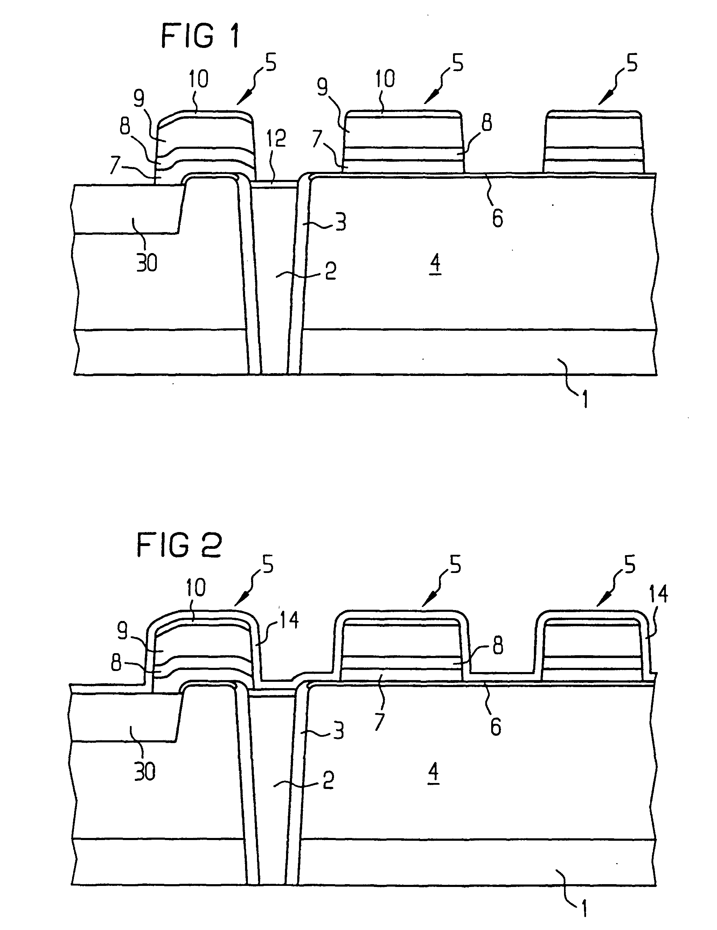

Die Erfindung wird nachfolgend anhand von Figuren der Zeichnung näher dargestellt. Die Fig. 1 bis 6 zeigen eine schematische Darstellungen des erfindungsgemäßen Verfahrens.

Die Erfindung geht von einer Struktur gemäß FIG. 1 aus. In einem Halbleitersubstrat 1 ist ein erstes Gebiet 2 eines ersten Leitfähigkeitstyps angeordnet. In diesem Beispiel ist dieses Gebiet die obere, p-dotierte Polysiliziumfüllung eines Grabenkondensators. Das Gebiet 2 ist durch eine Siliziumdioxidschicht 3, ein sogenannter "Collar", und eine Oxid-Nitrid-Oxid-Schicht (nicht gezeigt) von dem Substrat 1 getrennt. Weiterhin ist in dem Substrat 1 ein Bereich 4 eines zweiten Leitfähigkeitstyps angeordnet. In diesem Beispiel ist dieser Bereich eine N-Wanne für später noch zu bildenden P-Kanal Transistoren. Weiterhin ist in der N-Wanne 4 eine Grabenisolation 30 vorgesehen.

Über der N-Wanne 4 ist eine Schichtanordnung 5 angeordnet. Diese Schichtanordnung 5 umfaßt eine Isolationsschicht 6 ("Gateoxid"), eine leitende Schicht 7 ("Gate"), in diesem Fall eine hoch dotierte Polysiliziumschicht 7, eine Wolframsilizidschicht 8 und eine zweite Isolationsschicht 9. Die Isolationsschicht 9 besteht aus Siliziumnitrid. Auf der Isolationsschicht 9 ist eine Siliziumoxidschicht 10 als eine weitere Isolationsschicht angeordnet.

An Seiten der Schichtanordnung 5 ist ein dünner Oxidspacer (nicht gezeigt) vorgesehen, der einen gewissen Abstand zwischen der Schichtanordnung und einer LDD-Bor-Implantation (nicht gezeigt) in der N-Wanne 4 gewährleistet.

Auf der Oberfläche der Polysiliziumfüllung 2 befindet sich eine Siliziumoxidschicht 12, die durch einen TEOS-Prozeß erzeugt wurde.

Auf diese Halbleiterstruktur wird nun eine dritte Isolationsschicht 14 aufgebracht. Die dritte Isolationsschicht 14 ist bevorzugt eine Siliziumnitridschicht, die mittels eines LPCVD-Prozesses erzeugt wird. Die sich ergebende Struktur ist in Fig. 2 gezeigt.

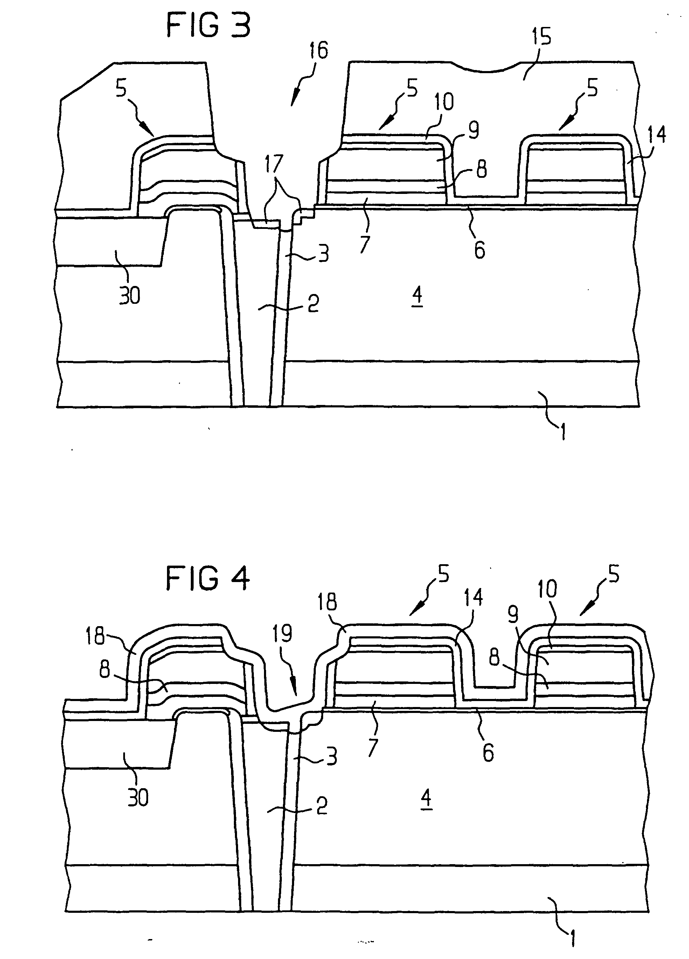

Auf diese Struktur wird nun ein Photolack 15 aufgebracht, der mit einer Maskentechnik strukturiert wird. Der Photolack wird dabei so strukturiert, daß durch eine nachfolgende Ätzung eine Öffnung 16 entsteht, so daß ein Teil der N-Wanne 4 und ein Teil der Polysiliziumfüllung 2 freigelegt sind. Durch diese Öffnung findet anschließend eine P-Dotierstoff-Implantation (Bor) statt. Danach ist der Dotierstoff 17 an der Oberfläche der N-Wanne und der Oberfläche der Polysiliziumfüllung 2 konzentriert. Die sich ergebende Struktur ist in Fig. 3 gezeigt.

Anschließend wird eine Polysiliziumschicht 18 mit einem LPCVD-Prozeß ganzflächig abgeschieden und eine Temperaturbehandlung durchgeführt. Bei dieser Temperaturbehandlung wird die Halbleiterstruktur für etwa 1 Stunde auf etwa 875°C aufgeheizt. Durch die Temperaturbehandlung diffundiert ein Teil der an der Oberfläche der N-Wanne 4 und an der Oberfläche der Polysiliziumfüllung konzentrierten Dotieratome 17 in die Polysiliziumschicht 18, wodurch der dotierte Abschnitt 19 der Polysiliziumschicht 18 entsteht. Außerdem diffundiert ein Teil der an der Oberfläche der N-Wanne 4 konzentrierten Dotieratome 17 weiter in die N-Wanne 4, wodurch das zweite Gebiet 20 des ersten Leitfähigkeitstyps entsteht. Die sich daraus ergebende Struktur ist in Fig. 4 gezeigt.

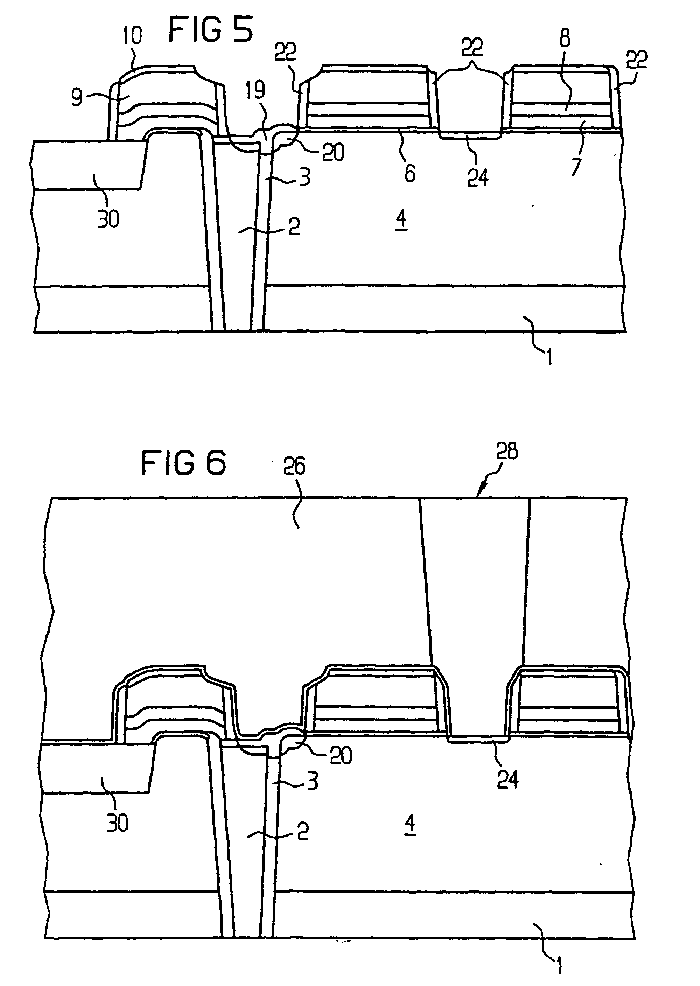

Anschließend wird der Teil der Siliziumschicht 18, in den keine Dotieratome diffundiert sind, entfernt. Dies geschieht beispielsweise durch eine naßchemische Ätzung mit einer KOH-Lauge. Nach dieser Behandlung bleibt nur der dotierte Abschnitt 19 der Polysiliziumschicht 18 zurück, der nun die beiden ersten und zweiten Gebiete des ersten Leitfähigkeitstyps (Gebiete 2 und 20) miteinander verbindet. Im folgenden findet eine Oxidation dieses dotierten Abschnitts 19 der Polysiliziumschicht 18 statt (etwa 825°C für etwa 1 Stunde) und die Isolationsschicht 14 wird anisotrop geätzt, so daß nur Isolationsbereiche 22 an den Seiten der Schichtanordnung 5 zurückbleiben. Nach der anisotropen Ätzung der dritten Isolationsschicht 14 wird wiederum ein Dotierstoff des ersten Leitfähigkeitstyps (Bor) implantiert, so daß ein drittes Gebiet 24 des ersten Leitfähigkeitstyps entsteht. Dabei können die Gebiete 20 und 24 als Source-/Drainbereiche eines Feldeffekttransistors verwendet werden. Die sich daraus ergebende Struktur ist in Fig. 5 gezeigt.

Auf die Struktur aus Fig. 5 wird nun eine PSG- oder BPSG-Schicht 26 abgeschieden und mittels CMP (Chemical Mechanical Polishing) planarisiert. Mittels einer Phototechnik wird anschließend ein Kontaktloch in diese Schicht 26 geätzt (Fig. 6).

Wie aus beschriebenem Beispiel der Erfindung ersichtlich, besitzt das erfindungsgemäße Verfahren den Vorteil, daß die normalerweise für einen "Surface-Strap" 19 anfallende Abscheidung einer zusätzlichen Nitridbarriereschicht entfallen kann. Die Funktion dieser zusätzlichen Nitridbarriereschicht wird von der ohnehin anfallenden dritten Isolationsschicht 14 übernommen, die im weiteren Verlauf des Verfahrens die seitlichen Isolationsbereiche ("Spacer") 22 an der auf dem Bereich 4 der zweiten Leitfähigkeitstyps angeordneten Schichtanordnung 5 ("Gatestack") bildet. Durch den Wegfall einer zusätzlichen Nitridbarriereschicht kann ein erheblicher Platzgewinn zwischen zwei Schichtanordnungen 5 ("Gatestacks") erzielt werden. Dieser Platzgewinn hat zur Folge, daß die Speicherzelle weiter verkleinert werden kann und später folgende Abscheidungen eines Dielektrikums 26 bzw. das Ätzen von Kontaktlöchern 28 einfacher durchzuführen sind.

Darüber hinaus wird durch die Tatsache, daß das dritte Gebiet 24 des ersten Leitfähigkeitstyps erst nach der Temperaturbehandlung zur Ausdiffusion des Dotierstoff 17 in die Polysiliziumschicht 18 erzeugt wird, die Diffusion des Dotierstoffes unter die erste Isolationsschicht 6 der Schichtanordnung 5 erheblich reduziert. Dies führt zu einer Verringerung der elektrischen Felder in diesem Bereich und somit zu einer Verminderung der "GIDL"-Leckströme ("gate induced drain leakage") und zur Verbesserung des Verhaltens des Transistors, der aus der Schichtanordnung 5 und dem zweiten sowie dem dritten Gebiet 20, 24 des ersten Leitfähigkeitstyps gebildet werden kann. Bei Anwendung des erfindungsgemäßen Verfahrens in einer Speicherzelle ergibt sich somit eine längere Verweilzeit der Information in der Zelle ("Retention Performance"). Durch die verringerte Ausdiffusion des Dotierstoff unter die erste Isolationsschicht 6 der Schichtanordnung 5 kann auch die Dicke der Isolationsbereiche 22 an den Seiten der Schichtanordnung weiter verringert werden, was wiederum zu einem erheblichen Platzgewinn zwischen zwei Schichtanordnungen 5 ("Gatestacks") zur Folge hat. Auch dieser Platzgewinn hat zur Folge, daß die Speicherzelle weiter verkleinert werden kann und später folgende Abscheidungen eines Dielektrikum 26 bzw. das Ätzen von Kontaktlöchern 28 einfacher durchzuführen sind.

## Patentansprüche

1. Verfahren zur Erzeugung einer leitenden Verbindung (19) zwischen zumindest zwei Gebieten (2, 20) eines ersten Leitfähigkeitstyps, wobei zumindest eines der Gebiete (20) ein Source-/Draingebiet eines Transistors ist, mit den Schritten:
a) eine Halbleiterstruktur mit einem Substrat (1), in welchem zumindest ein erstes Gebiet (2) des ersten Leitfähigkeitstyps und davon beabstandet ein Bereich (4) eines zweiten Leitfähigkeitstyps ausgebildet sind, und einer auf dem Bereich (4) des zweiten Leitfähigkeitstyps angeordneten Schichtanordnung (5), welche zumindest eine erste Isolationsschicht (6), eine leitende Schicht (7) und eine zweite Isolationsschicht (9) umfaßt, wird bereitgestellt,
b) auf die Halbleiterstruktur wird eine dritte Isolationsschicht (14) aufgebracht,
c) mit einer Phototechnik wird eine Öffnung (16) über zumindest einem Teil des Bereichs (4) des zweiten Leitfähigkeitstyps und zumindest einem Teil des ersten Gebiets (2) des ersten Leitfähigkeitstyps erzeugt,
d) durch die Öffnung (16) wird ein Dotierstoff (17) des ersten Leitfähigkeitstyps in zumindest einen Teil des Bereichs (4) des zweiten Leitfähigkeitstyps eingebracht,
e) auf die Halbleiterstruktur wird eine Polysiliziumschicht (18) aufgebracht und eine Temperaturbehandlung durchgeführt, so daß ein Teil des Dotierstoffes (17) des ersten Leitfähigkeitstyps in die Polysiliziumschicht (18) und ein Teil des Dotierstoffes (17) des ersten Leitfähigkeitstyps in den Bereich (4) des zweiten Leitfähigkeitstyps diffundiert, so daß ein zweites Gebiet (20) des ersten Leitfähigkeitstyps in dem Substrat (1) entsteht,
f) der Teil der Polysiliziumschicht (18), in den kein Dotierstoff (17) des ersten Leitfähigkeitstyps diffundiert ist, wird entfernt,
g) die dritte Isolationsschicht (14) wird bis auf Isolationsbereiche (22) entfernt, die an den Seiten der Schichtanordnung (5) zurückbleiben,
h) ein Dotierstoff des ersten Leitfähigkeitstyps wird in zumindest einen Teil des Bereichs (4) des zweiten Leitfähigkeitstyps eingebracht, so daß ein drittes Gebiet (24) des ersten Leitfähigkeitstyps entsteht.

2. Verfahren nach Anspruch 1,
**dadurch gekennzeichnet, daß** die dritte Isolationsschicht (14) eine Siliziumnitridschicht ist.

3. Verfahren nach Anspruch 1 oder 2,
**dadurch gekennzeichnet , daß** auf der ersten leitenden Schicht (7) eine zweite leitende Schicht (8) vorgesehen ist.

4. Verfahren nach Anspruch 3,
**dadurch gekennzeichnet, daß** die erste leitende Schicht (7) eine dotierte Polysiliziumschicht und die zweite leitende Schicht (8) eine Wolframsilizidschicht ist.

5. Verfahren nach einem der Ansprüche 1 bis 4,
**dadurch gekennzeichnet, daß** vor Schritt b) eine dünne Oxidschicht (10) aufgebracht wird.

6. Verfahren nach einem der Ansprüche 1 bis 5,
**dadurch gekennzeichnet ,**
**daß** vor Schritt b) ein Dotierstoff des ersten Leitfähigkeitstyps in zumindest einen Teil des Bereichs des zweiten Leitfähigkeitstyps eingebracht wird.

7. Verfahren nach einem der Ansprüche 1 bis 6,
**dadurch gekennzeichnet,**
**daß** die Dotierstoffe des ersten Leitfähigkeitstyps implantiert werden.

8. Verfahren nach einem der Ansprüche 1 bis 7,
**dadurch gekennzeichnet,**
**daß** der Teil der Polysiliziumschicht (18), in den kein Dotierstoff des ersten Leitfähigkeitstyps diffundiert ist, durch eine selektive Naßätzung mit KOH-Lauge entfernt wird.

9. Verfahren nach einem der Ansprüche 1 bis 8,
**dadurch gekennzeichnet,**
**daß** der verbleibende Teil (19) der Polysiliziumschicht (18) oxidiert wird.

10. Verfahren nach einem der Ansprüche 1 bis 9,
**dadurch gekennzeichnet,**
**daß** als Dotierstoff des ersten Leitfähigkeitstyps Bor gewählt wird.

## Claims

1. Method for producing a conductive connection (19) between at least two regions (2, 20) of a first conductivity type, at least one of the regions (20) being a source/drain region of a transistor, having the following steps:
a) a semiconductor structure having a substrate (1), in which at least a first region (2) of the first conductivity type and, spaced apart therefrom, a region (4) of a second conductivity type are formed, and a layer arrangement (5), which is arranged on the region (4) of the second conductivity type and comprises at least a first insulation layer (6), a conductive layer (7), and a second insulation layer (9), is provided,
b) a third insulation layer (14) is applied to the semiconductor structure,
c) using a phototechnology, an opening (16) is produced over at least part of the region (4) of the second conductivity type and at least part of the first region (2) of the first conductivity type,
d) through the opening (16), a dopant (17) of the first conductivity type is introduced into at least part of the region (4) of the second conductivity type,
e) a polysilicon layer (18) is applied to the semiconductor structure and a thermal treatment is carried out, with the result that part of the dopant (17) of the first conductivity type diffuses into the polysilicon layer (18) and part of the dopant (17) of the first conductivity type diffuses into the region (4) of the second conductivity type, thereby producing a second region (20) of the first conductivity type in the substrate (1),
f) that part of the polysilicon layer (18) into which no dopant (17) of the first conductivity type has diffused is removed,
g) the third insulation layer (14) is removed except for insulation regions (22) which remain on the sides of the layer arrangement (5),
h) a dopant of the first conductivity type is introduced into at least part of the region (4) of the second conductivity type, thereby producing a third region (24) of the first conductivity type.

2. Method according to Claim 1,
**characterized in that** the third insulation layer (14) is a silicon nitride layer.

3. Method according to Claim 1 or 2,
**characterized in that** a second conductive layer (8) is provided on the first conductive layer (7).

4. Method according to Claim 3,
**characterized in that** the first conductive layer (7) is a doped polysilicon layer and the second conductive layer (8) is a tungsten silicide layer.

5. Method according to one of Claims 1 to 4,
**characterized in that**, before step b), a thin oxide layer (10) is applied.

6. Method according to one of Claims 1 to 5,
**characterized in that**, before step b), a dopant of the first conductivity type is introduced into at least part of the region of the second conductivity type.

7. Method according to one of Claims 1 to 6,
**characterized in that** the dopants of the first conductivity type are implanted.

8. Method according to one of Claims 1 to 7,
**characterized in that** that part of the polysilicon layer (18) into which no dopant of the first conductivity type diffused is removed by selective wet etching using KOH alkaline solution.

9. Method according to one of Claims 1 to 8,
**characterized in that** the remaining part (19) of the polysilicon layer (18) is oxidized.

10. Method according to one of Claims 1 to 9,
**characterized in that** boron is chosen as dopant of the first conductivity type.

## Revendications

1. Procédé de production d'une structure (19) d'interconnexion entre au moins deux zones (2, 20) d'un premier type de conductivité, au moins l'une des zones (20) étant une zone de source/drain d'un transistor, comprenant les stades :
a) on prépare une structure à semi-conducteur comprenant un substrat (1) dans lequel sont constituées au moins une première zone (2) du premier type de conductivité et à distance de celle-ci une région (4) d'un second type de conductivité et un agencement (5) stratifié qui est disposé sur la région (4) du second type de conductivité et qui comprend au moins une première couche (6) d'isolement, une couche (7) conductrice et une deuxième couche (9) d'isolement,
b) on dépose sur la structure à semi-conducteur une troisième couche (14) d'isolement,
c) par une technique photographique, on produit une ouverture (16) sur au moins une partie de la région (4) du second type de conductivité et sur au moins une partie de la première zone (2) du premier type de conductivité,
d) on introduit par l'ouverture (16) une substance (17)de dopage du premier type de conductivité dans au moins une partie de la région (4) du second type de conductivité,
e) on dépose une couche de polysilicium sur la structure à semi-conducteur et on effectue un traitement thermique de sorte qu'une partie de la substance (17) de dopage du premier type de conductivité diffuse dans la couche (18) de polysilicium et qu'une partie de la substance (17) de dopage du premier type de conductivité diffuse dans la région (4) du second type de conductivité de manière à former une deuxième zone (20) du premier type de conductivité dans le substrat (1),
f) on élimine la partie de la couche (18) de polysilicium, dans laquelle de la substance (17) de dopage du premier type de conductivité n'a pas diffusé,
g) on élimine la troisième couche (14) d'isolement à l'exception de régions (22) d'isolement qui restent sur les côtés de l'agencement (5) stratifié,
h) on introduit une substance de dopage du premier type de conductivité dans au moins une partie de la région (4) du second type de conductivité de manière à former une troisième zone (24) du premier type de conductivité.

2. Procédé suivant la revendication 1, **caractérisé en ce que** la troisième couche (14) d'isolement est une couche de nitrure de silicium.

3. Procédé suivant la revendication 1 ou 2, **caractérisé en ce qu'**il est prévu sur la première couche (7) conductrice une deuxième couche (8) conductrice.

4. Procédé suivant la revendication 3, **caractérisé en ce que** la première couche (7) conductrice est une couche dopée de polysilicium et la deuxième couche (8) conductrice est une couche de siliciure de tungstène.

5. Procédé suivant les revendications 1 à 4, **caractérisé en ce que** l'on dépose une mince couche (10) d'oxyde avant le stade b).

6. Procédé suivant l'une des revendications 1 à 5, **caractérisé en ce que** l'on introduit avant le stade b) une substance de dopage du premier type de conductivité dans au moins une partie de la région du second type de conductivité.

7. Procédé suivant l'une des revendications 1 à 7, **caractérisé en ce que** l'on implante les substances de dopage du premier type de conductivité.

8. Procédé suivant l'une des revendications 1 à 7, **caractérisé en ce que** l'on élimine par attaque chimique sélective en voie humide par de la lessive de KOH la partie de la couche (18) de polysilicium, dans laquelle de la substance de dopage du premier type de conductivité n'a pas diffusé.

9. Procédé suivant l'une des revendications 1 à 8, **caractérisé en ce que** l'on oxyde la partie (9) restante de la couche (18) de polysilicium.

10. Procédé suivant l'une des revendications 1 à 9, **caractérisé en ce que** l'on choisi du bore comme substance de dopage du premier type de conductivité.
